**Europäisches Patentamt**

**European Patent Office**

**Office européen des brevets**

(19)

(11)  **EP 1 367 727 A1**

(12)  **EUROPÄISCHE PATENTANMELDUNG**

(43) Veröffentlichungstag:
03.12.2003  Patentblatt 2003/49

(51) Int Cl.⁷: **H03M 13/15**

(21) Anmeldenummer: **02011975.6**

(22) Anmeldetag: **29.05.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(71) Anmelder: **SIEMENS AKTIENGESELLSCHAFT**
**80333 München (DE)**

(72) Erfinder:
• **Cost, Elena Dr.**
**85748 Garching (DE)**

• **Fedorenko, Sergei Dr.**
**198255 St Pretersburg (RU)**
• **Krouk, Evgueni Prof.**
**196211 St. Petersburg (RU)**
• **Lott, Matthias**
**81477 München (DE)**
• **Schultz, Egon Dr.**
**80993 München (DE)**
• **Trifonov, Peter**
**195256 St. Petersburg (RU)**

(54)  **Verfahren und Kommunikationssystemvorrichtung zum Auffinden von Wurzeln eines Fehlerstellenpolynoms**

(57)  Die Erfindung bezieht sich auf ein Verfahren zum Auffinden von Wurzeln eines Fehlerstellenpolynoms in einem Kommunikationssystem, bei dem Wurzeln des Fehlerstellenpolynoms (F(x)) mit einem Polynomgrad (t) bestimmt werden.

Zur Beschleunigung und Vereinfachung der Berechnung wird ein Verfahren vorgeschlagen, bei dem die Bestimmung des Fehlerstellenpolynoms (F(x)) in zwei Verfahrensschritten durchgeführt wird,

- einem ersten Verfahrensschritt, bei dem das Fehlerstellenpolynom (F(x)) in eine Summe mit affinen Polynomen (Ai(x); i=1,2,...) zerlegt wird, wozu eine Teilmenge (j) von deren Wurzeln ($x_i$) bestimmt wird, und

- bei dem nach der Bestimmung der Teilmenge der Wurzeln ($x_i$) damit ein reduziertes Polynom (F'(x)) niedrigeren Grades (t-j) bestimmt wird, und

- einem zweiten Verfahrensschritt, bei dem für sich bekannte Wurzel-Auffindungs-Verfahren zum Auffinden der Wurzeln des reduzierten Polynoms (F'(x)) niedrigeren Grades (t-j) durchgeführt werden.

**Fig. 1**

EP 1 367 727 A1

**Beschreibung**

Die Erfindung bezieht sich auf ein Verfahren zum Auffinden von Wurzeln eines Fehlerstellenpolynoms mit den oberbegrifflichen Merkmalen des Patentanspruchs 1 bzw. eine Kommunikationssystemvorrichtung zum Durchführen eines solchen Verfahrens.

Bei der Übertragung von Daten in Kommunikationssystemen werden Algorithmen verwendet, mit welchen Daten vor einer Übertragung über eine Schnittstelle codiert und anschließend empfängerseitig decodiert werden. Außerdem werden Verfahren angewendet, die zum Auffinden von Übertragungsfehlern innerhalb einer Datenfolgen verwendet werden, um die Fehler direkt empfängerseitig oder nach einer entsprechend angeforderten Neuübertragung von Daten empfängerseitig korrigieren zu können. Reed-Solomon-Codes, wie sie aus z.B. M. Bossert, "Channel Coding", West Sussex, Wiley, 1988, bekannt sind, stellen eine sehr bekannte Klasse von fehlerkorrigierenden Codes in derzeit üblichen Kommunikationssystemen dar. Deren Anwendung macht eine effiziente Implementierung von Algorithmen bzw. Verfahren zum Codieren und Decodieren von Daten erforderlich.

Beim Decodieren von Daten, die gemäß dem Reed-Solomon-Code, BCH-Codes (Bose, Ray-Chaudhuri, Hocquenghem) oder einigen anderen Codes codiert wurden, ist eine der zeitaufwendigsten Verarbeitungsstufen das Auffinden der Wurzeln eines Fehlerstellenpolynoms. Im allgemeinen gibt es für diese Aufgabe keine anderen Algorithmen als die ausführliche Suche, die als Chien-Verfahren unter Verwendung von BCH-Codes aus US 3,278,729 bekannt ist.

Die Decodierungsleistungsfähigkeit soll durch Beschleunigen des Verfahrens bzw. eines Algorithmus zur Polynombestimmung verbessert werden.

Die Reed-Solomon-Codierung wendet jeweils auf einen Block aus k Teilnehmerdatensymbolen 2t Redundanzsymbole zum Erzeugen eines Codeworts an. Dabei stellt t die gewünschte Fehlerkorrekturkapazität des Codes dar. Bei dem Reed-Solomon-Code gibt es k+2t Symbole in einem Codewort, wobei der Reed-Solomon-Code die n-Bit Symbole als Elemente eines finiten Galois-Feldes $GF(2^m)$ betrachtet, wo n die Reed-Solomon-Codewortlänge ist und ein Symbol des Reed-Solomon-Codes aus m Bit besteht. Für den Aufbau eines Galois-Feldes $GF(2^m)$ ist ein dieses definierendes primitives Polynom P(x) vom Grad m erforderlich.

Bekannte Decodierer implementieren üblicherweise die Chien-Suche, bei der ein Polynom F(x) mit

$$F(x) \;=\; \sum_{i=0}^{t} f_i x^i$$

für alle Punkte eines finiten Feldes, insbesondere des Galois-Feldes $GF(2^m)$ bestimmt wird. Die Bestimmung der Punkte des finiten Feldes $GF(2^m)$ kann unter Verwendung der Hörner'schen Regeln oder des originalen Chien's Schema durchgeführt werden, wobei ein gesamter Zeitaufwand von $(2^m-1)t(C_{add}+ C_{mul})$ erzielt wird. Dabei sind $C_{add}$ und $C_{mul}$ zeitlich aufwendiger gebildete Größen aus einer Addition und Multiplikation über $GF(2^m)$.

Der Zeitaufwand könnte durch das Implementieren paralleler Polynom-Bestimmungsschaltungen für jedes Element des finiden Feldes $GF(2^m)$ reduziert werden. Dies würde jedoch eine große Schaltung erforderlich machen. Für Polynome niedrigen Grades können die Wurzeln analytisch, z.B. gemäß US 5.905,740, unter Verwendung des Berlekamp-Rumsey-Solomon-Algorithmus, siehe E.R. Berlekamp, "Algebraic coding theory", New York, McGraw-Hill, 1968, oder klassischer Verfahren zum Auffinden von Wurzeln, z.B. gemäß B.L. Van der Waerden, "Algebra", Springer-Verlag, 1991, gefunden werden.

Die Aufgabe der Erfindung besteht darin, ein Verfahren zum Bestimmen der Wurzeln eines Fehlerstellenpolynoms zum Decodieren von Daten insbesondere in einem Kommunikationssystem bzw. durch eine Kommunikationssystemvorrichtung zum Durchführen eines solchen Verfahrens zu verbessern.

Insbesondere soll die Decodierungsleistungsfähigkeit durch Beschleunigen des Verfahrens zur Polynombestimmung sowie durch die Anwendung bekannter analytischer Verfahrensweisen für Polynome mit niedrigem Grad verbessert werden.

Diese Aufgabe wird durch ein Verfahren zum Auffinden von Wurzeln eines Fehlerstellenpolynoms mit den Merkmalen des Patentanspuchs 1 bzw. durch eine Kommunikationssystemvorrichtung zum Durchführen eines solchen Verfahrens mit den Merkmalen des Patentanspuchs 12 gelöst.

Das Verfahren betrifft somit einen zweistufigen Verfahrensablauf oder Algorithmus, wobei in der zweiten Stufe die klassischen Verfahren zum Auffinden einer Wurzel verwendet werden. Vorteilhaft ist dabei insbesondere die spezielle Polynomzerlegung des Fehlerstellenpolynoms.

Vorteilhafte Ausgestaltungen sind Gegenstand abhängiger Ansprüche.

Hervorzuheben sind insbesondere die Schritte (1) des Zerlegens eines Fehlerstellenpolynoms als ursprüngliches Polynom F(x) in eine Summe affiner Polynome, dann (2) des Anwendens einer Chien-Suche oder eines anderen Verfahrens auf diese affinen Polynome zum Auffinden der ersten j Nullstellen des Polynoms F(x), ferner (3) des Dividieren des Polynoms F(x) durch das Produkt aus j affinen Polynomen der ersten Ordnung mittels der Wurzeln, welche durch die j Nullstellen erhalten werden, um ein Polynom F'(x) mit der Ordnung t-j zu erhalten und letztendlich (4) des Anwendens analytischer bzw. algebraischer Verfahren auf das dabei erhaltene Polynom F'(x), um dessen t-j Nullstellen zu finden.

Ein Ausführungsbeispiel wird nachfolgend anhand der Zeichnung näher erläutert. Es zeigt die einzige

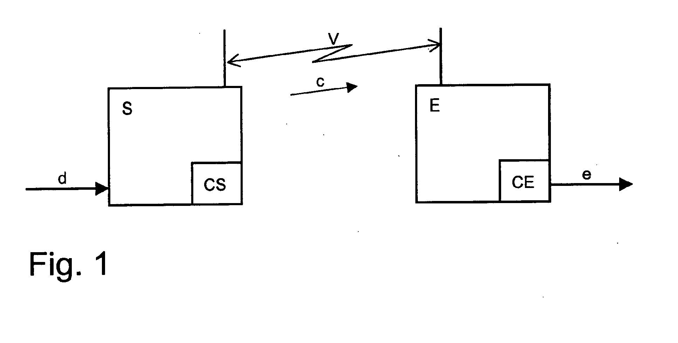

Fig. 1 eine Sendeeinrichtung und eine Empfangseinrichtung, welche über eine Schnittstelle miteinander kommunizieren und Einrichtungen zum Codieren bzw. Decodieren von Daten aufweisen.

Wie aus Fig. 1 ersichtlich, werden in Kommunikationssystemen Daten d einer Sendeeinrichtung S zugeführt, um über eine Schnittstelle, insbesondere eine Funkschnittstelle V zu einer Empfangseinrichtung E übertragen zu werden, aus der dann die empfangenen Daten e ausgegeben werden. Senderseitig werden die Daten d in der Sendeeinrichtung S in einer senderseitigen Datenverarbeitungseinrichtung CS codiert und als codierte Daten c über die Schnittstelle V übertragen. Empfängerseitig werden die codierten, empfangenen Daten c in einer empfängerseitigen Datenverarbeitungseinrichtung CE decodiert und auf Fehler bei der Übertragung über die Schnittstelle V untersucht. Im Falle einer fehlerhaften Übertragung werden die empfangenen Daten c soweit wie möglich bearbeitet bzw. rekonstruiert, so dass letztendlich die auszugebenden Daten e nach einer entsprechenden Rekonstruktion idealerweise den versendeten ursprünglichen Daten d entsprechen.

Die senderseitige und die empfängerseitige Datenverarbeitungseinrichtung CS bzw. CE weisen in zweckmäßiger Weise Prozessoren und Speichereinrichtungen zur Verarbeitung der Daten d, c bzw. e auf. Ferner sind in diesen Programme abgespeichert, um die einzelnen erforderlichen Verfahrensschritte durchzuführen. Alternativ können diese Datenverarbeitungseinrichtungen CS bzw. CE auch aus einzelnen elektronischen Bauelementen aufgebaut sein, welche die Daten entsprechend verarbeiten. Zu derartigen Bauelementen zählen neben Wiederständen und Kondensatoren insbesondere auch Transistoren.

Empfängerseitig werden die empfangenen Daten c decodiert und auf Übertragungsfehler hin untersucht. Beispielhafte Verfahren zum Decodieren von Daten, die mit verschiedenen Codes, insbesondere dem Reed-Solomon-Code oder BCH codiert wurden, werden mittels eines Fehlerstellenpolynoms untersucht, dessen Wurzeln aufzufinden sind.

Unter dem Auffinden der Wurzeln wird verstanden, dass zu einem Polynom

$$F(x) \; = \; \sum_{j}^{t} f_j x^j$$

mit $x_i$, $f_j \in GF(2^m)$ alle verschiedenen Nullstellen $x_i : F(x_i) = 0$ zu finden sind.

Dazu wird ein zweistufiges Verfahren, insbesondere ein zweistufiger Algorithmus verwendet, bei dem in einem ersten Schritt der Grad des ursprünglichen Polynoms F(x) reduziert und in einem zweiten Schritt eine für sich bekannte Polynombestimmung bzw. Polynom-Wurzelbestimmung bei reduziertem Polynomgrad durchgeführt wird.

Im ersten Verfahrensschritt wird der Grad des ursprünglichen Polynoms F(x) mit dem Grad t zum Erzeugen eines Polynoms F'(x) bzw. L(x) mit reduziertem Grad t - j reduziert, indem das ursprüngliche Polynom F(x) durch das Produkt

$$\prod_{i=1}^{j} (x - x_i)$$

dividiert wird, also

$$F'(x) \; = \; \frac{F(x)}{\prod_{i=1}^{j} (x \; - \; x_i)}$$

gilt, wobei $x_i$ mit i als ganzer Zahl zwischen 1 und j die Wurzeln bzw. Nullstellen darstellt, die mit Hilfe einer Chien-Suche für j < t bestimmt wurden.

Im zweiten Verfahrensschritt werden schnelle analytische Verfahren bzw. Algorithmen verwendet, um die verbleibenden t - j Wurzeln des hinsichtlich des Grades reduzierten Polynoms F'(x) zu finden. Der Zeitaufwand der Chien-Suche wird dabei durch die Anzahl s, wie oft das hinsichtlich des Grades reduzierte Polynom F'(x) berechnet wird, bestimmt, wobei diese Anzahl zufällig bestimmt werden kann. Außerdem wird der Zeitaufwand durch die Dauer bestimmt, die für eine Berechnung des Polynoms F'(x) erforderlich ist. Dadurch können die Komplexität der Berechnungen und damit der insgesamt erforderliche Zeitaufwand reduziert werden, wenn die Chien-Suche nach einer ausreichenden Reduzierung des Grad des Polynoms beendet wird.

Die Polynomberechnung kann mit einem üblichen Verfahren unter Verwendung beispielsweise des Horner'schen Schemas durchgeführt werden, welches sich nur für die Berechnung eines Polynoms an einem Punkt als optimal herausgestellt hat. Für einige spezielle Klassen von Polynomen sind auch effizientere Algorithmen bzw. Verfahren zur Bestimmung von deren Wurzeln allgemein bekannt und anwendbar.

Bei der Durchführung dieser Verfahren zur Polynomberechnung werden zweckmäßiger Weise zwei Grundgedanken berücksichtigt.

Erstens wird ein beliebiges Polynom L(x) über ein finites Feld, insbesondere ein Galois-Feld GF($2^m$) linearisiert bezeichnet, falls

$$\mathtt{L(x)} \;=\; \sum_i f_i \mathtt{x}^{2^i}$$

gilt. Falls x $\in$ GF($2^m$) in einer Standardbasis mit $\alpha$ ist primitives Element aus GF($2^m$) bei digitalen Zahlen $x_i$ mit Werten 0 und 1 und m als Grad des Polynoms bzw. der verschiedenen Nullstellen repräsentiert wird, d. h. insbesondere

$$\mathtt{x} \;=\; \sum_{i=0}^{m-1} x_i \alpha^i$$

gilt, dann gilt

$$\mathtt{L(x)} \;=\; \sum_{i=0}^{m-1} x_i \mathtt{L}(\alpha^i) \,.$$

Daher ist es möglich, linearisierte Polynome bei jedem Punkt des finiten Feldes GF($2^m$) unter Verwendung sehr kleiner und zuvor berechneter Tabellen zu bestimmen bzw. zu berechnen.

Der zweite Grundgedanke besteht darin, dass affine Polynome A(x) verwendet werden können, wobei ein Polynom A(x) als affin bezeichnet wird, falls A(x)= $\beta$ + L(x) für einige konstante $\beta \in$ GF($2^m$) und das linearisierte Polynom L(x) gilt.

Die vorstehende Bedingung ermöglicht die Bestimmung von affinen Polynomen A(x) mit nur einer Addition für jedes $x_i \in$ GF($2^m$), falls alle $x_i$ in deren Vektordarstellung als Gray-Code dargestellt sind. Der Gray-Code ist eine Reihenfolge aller binärer Vektoren mit der Länge m, so dass sich nur ein Bit von einem Eintrag zum nächsten ändert. Für sich genommen ist dies bekannt aus US 2,632,058.

Nachfolgend soll daher vorzugsweise davon ausgegangen werden, dass die Vektordarstellungen aller $x_i \in$ GF($2^m$) gemäß dem sogenannten Gray-Code mit $x_0$=0 und folglich A($x_0$)= $\beta$ geordnet werden. Dann gilt für den Abstand der Punkte $x_{i-1}$ und $x_i$ als Abstand dist ($x_{i-1}$, $x_i$) = 1. Dies impliziert A($x_i$)= A($x_{i-1}$) + L ($\alpha \delta (x_i, x_{i-1})$), wobei $\delta (x_i x_{i-1})$ die Position anzeigt, in welcher die Vektordarstellung von $x_i$ von $x_{i-1}$ abweicht. Die vorstehende Gleichung beschreibt somit den Algorithmus zum Bestimmen von A(x) bei allen Punkten des Feldes GF($2^m$). Es folgt, dass es möglich ist, jeden Wert A(x) mit nur einer Addition zu berechnen, wenn ein affines Polynom bei allen Punkten des Feldes zu bestimmen ist.

Diese Technik kann zum Berechnen bzw. Bestimmen irgendeines Polynoms verwendet werden, falls dieses in eine Summe von Multiplikationen von affinen Polynomen zerlegbar ist.

Wie dies für sich genommen aus S. V. Fedorenko, P. V. Trifonov, "Finding roots of polynomials over finite fields", eingesandt an IEEE Transactions on Communications, August 2001, für sich genommen bekannt ist, ist ein Verfahren zum Zerlegen irgendeines Polynoms in eine Summe von Multiplikationen von affinen Polynomen vorteilhaft.

In vielen Fällen ist es möglich, die Anzahl von Verfahrensschritten bzw. Operationen in dem Polynom-Bestimmungsverfahren bzw. Polynom-Bestimmungsalgorithmus zu reduzieren. Insbesondere kann jegliches Polynom mit einem Grad nicht höher als 8, wie es beispielsweise in Decodern mit dem Reed-Solomon-Code RS(255,239,17) vorkommt, zerlegt werden zu

$$F(x) = \sum_{i=0}^{8} f_i x^i = A_1(x) + x^3 (A_2(x) + f_6 x^3),$$

wobei

$$A_1(x) = f_0 + L_1(x) = f_0 + f_1 x + f_2 x^2 + f_4 x^4 + f_8 x^8$$

und

$$A_2(x) = f_3 + L_2(x) = f_3 + f_5 X^2 + f_7 x^4$$

gilt. Dabei sind $A_1$ und $A_2$ affine Polynome.

Polynome vom Grad nicht Höher als 16, beispielsweise gemäß dem Reed-Solomon-Code RS(255,223,33), können zerlegt werden zu einem Polynom

$$F(x) = A_1(x) + x^3 (A_2(x) + x^3 (f_6 + x^3 (A_3(x) + x^3 (A_4(x) + f_{15} x^3))))\,,$$

wobei

$$A_1(x) = f_0 + f_1 x + f_2 x^2 + f_4 x^4 + f_8 x^8 + f_{16} x^{16},$$

$$A_2(x) = f_3 + f_5^{x2} + f_7 x^4\,,$$

$$A_3(x) = f_9 + f_{10} x + f_{11} x^2 + f_{13} x^4$$

und

$$A_4(x) = f_{12} + f_{14} x^2$$

gilt. Entsprechend ist es erforderlich, $A_i(x)$ mit i=1,2,3,4 bei allen Punkten des finiten Feldes $GF(2^m)$ zu bestimmen und F(x) unter Verwendung der geeigneten Zerlegung zu berechnen. Nach der Bestimmung bzw. Erfassung der Wurzeln $X_i$ sollte das Polynom F(x) durch $(x-X_i)$ bzw. entsprechende Polynome erster Ordnung dividiert werden, wie dies vorstehend bereits beschrieben ist, um das reduzierte Polynom F'(x) zu bestimmen.

Daher ist es nach der Erfassung bzw. Bestimmung von t-4 Wurzeln möglich, klassische Wurzel-Auffindungstechniken durchzuführen bzw. aufzurufen, um dann die Wurzeln des reduzierten Polynoms F'(x) zu bestimmen. Dies können beispielsweise ein BRS-Algorithmus (BRS: Berlekamp-Rumsey-Solomon ), z.B. gemäß E.R. Berlekamp, "Algebraic coding theory", New York, McGraw-Hill, 1968, oder Verfahren zum Lösen von Wurzelausdrücken von Polynomen sein, wie sie z.B. aus B.L. Van der Waerden, "Algebra", Springer Verlag, 1991, bekannt sind.

Die Zeitkomplexität dieses Verfahrens bzw. Algorithmus zum bestimmen eines Polynoms mit dem Grad t=8 ist gleich

$$W_{eval} = 8(6C_{add} + 6C_{mul} + 3C_{exp}) + S(C_{exp} + 2C_{mul} + 4C_{add}),$$

wobei $C_{add}$, $C_{mul}$ bzw. $C_{exp}$ zusammengesetzte Größen aus einer Addition, Multiplikation bzw. Exponentenbildung über das finite Feld $GF(2^8)$ sind und dabei s die Anzahl der zu verarbeitenden Punkte darstellt.

Falls ein analytischer Algorithmus zu Auffinden von Wurzeln bzw. Nullstellen von Polynomen des Grades 4 verwendet wird, gleicht der durchschnittliche Wert

$$\bar{s} = (t\text{-}4)\,\frac{n+1}{t+1} = 113,8.$$

Selbst wenn kein analytischer Algorithmus verwendet wird, reduziert sich die durchschnittliche Komplexität des Wurzeln auffindenden Verfahrens oder Algorithmus von 4080 Operationen für die Chien-Suche auf 1712 Operationen für den schnellen Polynom-Bestimmungsalgorithmus. Für t=16 reduziert sich die Komplexität von 8160 Operationen auf 3822 Operationen.

Besonders Vorteilhaft ist die Anwendung derartiger Verfahren in Verbindung mit der Kanalqualität, wenn dafür gesorgt wird, dass der zugrundeliegende Kanal für die Übertragung über die Schnittstelle V gute Übertragungseigenschaften bietet. Dies führt zu einer typischerweise sehr geringen Anzahl von Fehlern in den decodierten Daten bzw. Datenworten. In einem solchen Fall ist es möglich, einen analytischen Algorithmus unmittelbar dann aufzurufen, wenn dies erforderlich ist, wodurch die Decodierungsverzögerungszeit ausreichend bzw. noch weiter reduziert werden kann.

Die vorstehend beschriebene Verfahrensweise dient somit insbesondere einer effizienten Berechnung bzw. Bestimmung des Fehlerstellenpolynoms in der Decodierungsstufe von zyklischen Codes, BCH-Codes, Reed-Solomon-Codes und Goppa-Codes. Die Anwendung ist natürlich auch bei anderen Codierungsverfahren möglich. Hervorzuheben ist insbesondere die Zerlegung des Fehlerstellenpolynoms in eine Summe von Multiplikationen von affinen Polynomen, welche wiederum mit Hilfe für sich bekannter analytischer Verfahrensweisen bestimmt werden können.

Eine Anwendung ist insbesondere für die Übertragung von Daten mit einer hohen Datenrate in funkgestützten Systemen vorteilhaft. Insbesondere bei der Anwendung in zukünftigen Systemen zur Übertragung von Daten mit deutlich höheren Datenraten als den heutigen Datenraten wird diese Verfahrensweise besonders vorteilhaft anwendbar sein.

**Patentansprüche**

1. Verfahren zum Auffinden von Wurzeln eines Fehlerstellenpolynoms in einem Kommunikationssystem, bei dem

   - Wurzeln $(x_i)$ des Fehlerstellenpolynoms $(F(x))$ mit einem Polynomgrad $(t)$ bestimmt werden,

   **dadurch gekennzeichnet, dass**

   - die Bestimmung der Wurzeln $(x_i)$ des Fehlerstellenpolynoms $(F(x))$ in zwei Verfahrensschritten durchgeführt wird,
   - einem ersten Verfahrensschritt, bei dem das Fehlerstellenpolynom $(F(x))$ in eine Summe mit affinen Polynomen $(Ai(x); i=1,2,...)$ zerlegt wird, wozu eine Teilmenge $(j)$ von deren Wurzeln $(x_i)$ bestimmt wird, und
   - bei dem nach der Bestimmung der Teilmenge der Wurzeln $(x_i)$ damit ein reduziertes Polynom $(F'(x))$ niedrigeren Grades $(t\text{-}j)$ bestimmt wird, und
   - einem zweiten Verfahrensschritt, bei dem für sich bekannte Wurzel-Auffindungs-verfahren zum Auffinden der Wurzeln des reduzierten Polynoms $(F'(x))$ niedrigeren Grades $(t\text{-}j)$ durchgeführt werden.

2. Verfahren nach Anspruch 1, bei dem die Zerlegung des Fehlerstellenpolynoms $(F'(x))$ in eine Summe von Multiplikationen von affinen Polynomen durchgeführt wird.

3. Verfahren nach einem vorstehenden Anspruch, bei dem im ersten Verfahrensschritt der Grad des Fehlerstellenpolynoms $F(x)$ mit dem ursprünglichen Grad $(t)$ zum Erzeugen des Polynoms $F'(x)$ mit reduziertem Grad $(t\text{-}j)$ reduziert wird, indem das ursprüngliche Fehlerstellenpolynom $F(x)$ durch das Produkt

$$\prod_{i=1}^{j}(x - x_i)$$

dividiert wird, also

$$F'(x) = \frac{F(x)}{\prod_{i=1}^{j}(x - x_i)}$$

gilt, wobei $x_i$ mit i als ganzer Zahl zwischen 1 und j die Wurzeln darstellt, die mit Hilfe insbesondere einer Chien-Suche für j < t zuvor bestimmt wurden.

**4.** Verfahren nach einem vorstehenden Anspruch, bei dem
im zweiten Verfahrensschritt schnelle algebraische bzw. analytische Verfahren bzw. Algorithmen verwendet werden, um die verbleibenden t - j Wurzeln des hinsichtlich des Grades reduzierten Polynoms (F'(x)) zu finden, insbesondere Berlekamp-Rumsey-Solomon-Verfahren.

**5.** Verfahren nach einem vorstehenden Anspruch, bei dem
der Zeitaufwand der Wurzel-Suche, insbesondere einer Chien-Suche, durch die Anzahl(s), wie oft das hinsichtlich des Grades (j) reduzierte Polynom F'(x) berechnet wird, bestimmt wird.

**6.** Verfahren nach einem vorstehenden Anspruch, bei dem
der Zeitaufwand der Wurzel-Suche durch die Dauer bestimmt wird, die für eine Berechnung des Polynoms F'(x) mit reduziertem Grad (t-j) erforderlich ist.

**7.** Verfahren nach einem vorstehenden Anspruch, bei dem
als Fehlerstellenpolynom (F(x)) über ein finites Feld, insbesondere ein Galois-Feld GF($2^m$) ein linearisiertes Polynom L(x) verwendet wird, wobei insbesondere

$$L(x) = \sum_i f_i x^{2^i}$$

gilt und dies mit $x \in GF(2^m)$ in einer Standardbasis $\alpha^i$ repräsentiert wird, d. h.

$$x = \sum_{i=0}^{m-1} x_i \alpha^i$$

gilt und somit

$$L(x) = \sum_{i=0}^{m-1} x_i L(\alpha^i).$$

**8.** Verfahren nach Anspruch 7, bei dem
ein affines Polynom (Ai(x)) bei jedem Punkt des finiten Feldes (GF($2^m$)) unter Verwendung sehr kleiner und zuvor berechneter Tabellen bestimmbar ist.

**9.** Verfahren nach einem vorstehenden Anspruch, bei dem
das Fehlerstellenpolynom (F(x)) mit einem Grad (t) nicht höher als 8 zerlegt wird zu einem Polynom

$$F(x) = A_1(x) + x^3 (A_2(x) + f_6 x^3) ,$$

mit

$$A_1(x) = f_0 + f_1 x + f_2 x^2 + f_4 x^4 + f_8 x^8$$

bzw.

$$A_2(x) = f_3 + f_5 x^2 + f_7 x^4.$$

10. Verfahren nach einem der Ansprüche 1 - 8, bei dem
das Fehlerstellenpolynom (F(x)) vom Grad (t) nicht höher als 16 zerlegt wird zu einem Polynom

$$F(x) = A_1(x) + x^3(A_2(x) + x^3(f_6 + x^3(A_3(x) + x^3(A_4(x) +$$

$$f_{15}x^3)))),$$

mit

$$A_1(x) = f_0 + f_1 x + f_2 x^2 + f_4 x^4 + f_8 x^8 + f_{16}x^{16},$$

$$A_2(x) = f_3 + f_5 x^2 + f_7 X^4,$$

$$A_3(x) = f_9 + f_{10}X + f_{11}x^2 + f_{13}x^4$$

und

$$A_4(x) = f_{12} + f_{14}X^2 .$$

11. Verfahren nach Anspruch 9 oder 10, bei dem
die $A_i(x)$ mit i=1,2 bzw. i=1,2,...4 bei allen Punkten des finiten Feldes GF($2^m$) bestimmt werden und das Fehlerstellenpolynom F(x) unter Verwendung der geeigneten Zerlegung bestimmt wird.

12. Kommunikationssystemvorrichtung mit

- einer Schnittstelleneinrichtung zum Empfangen codierter Daten (c),
- einer Ausgabeeinrichtung zum Ausgeben decodierter und rekonstruierter Daten (e) und
- einer Datenverarbeitungseinrichtung (CE) zum zeitweiligen Speichern und Verarbeiten der empfangenen Daten (c) zu den auszugebenden Daten (e) gemäß einem Verfahren nach einem vorstehenden Anspruch.

Fig. 1

Europäisches
Patentamt

# EUROPÄISCHER RECHERCHENBERICHT

Nummer der Anmeldung

EP 02 01 1975

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 099 160 A (FLAGG HOWARD LANG) 4. Juli 1978 (1978-07-04) * das ganze Dokument * --- | 1-12 | H03M13/15 |
| A | US 5 379 305 A (WENG LIH-JYH) 3. Januar 1995 (1995-01-03) * das ganze Dokument * --- | 1-12 | |
| A,D | US 3 278 729 A (CHIEN ROBERT T) 11. Oktober 1966 (1966-10-11) * das ganze Dokument * --- | 1-12 | |
| A,D | BERLEKAMP E: "Algebraic Coding Theory" ALGEBRAIC CODING THEORY, NEW YORK, MCGRAW-HILL, US, 1968, Seiten 12-20, XP002132710 * das ganze Dokument * ----- | 1-12 | |

RECHERCHIERTE SACHGEBIETE (Int.Cl.7)

H03M

Der vorliegende Recherchenbericht wurde für alle Patentansprüche erstellt

| Recherchenort | Abschlußdatum der Recherche | Prüfer |
|---|---|---|
| DEN HAAG | 9. Dezember 2002 | Barel-Faucheux, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**          EP 02 01 1975

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-12-2002

| Im Recherchenbericht angeführtes Patentdokument | Datum der Veröffentlichung | Mitglied(er) der Patentfamilie | Datum der Veröffentlichung |
|---|---|---|---|
| US 4099160 A | 04-07-1978 | GB 1531694 A<br>JP 53010239 A | 08-11-1978<br>30-01-1978 |
| US 5379305 A | 03-01-1995 | DE 4324299 A1<br>GB 2269034 A ,B<br>JP 6188746 A<br>NL 9301240 A | 27-01-1994<br>26-01-1994<br>08-07-1994<br>16-02-1994 |
| US 3278729 A | 11-10-1966 | KEINE | |

EPO FORM P0461

Für nähere Einzelheiten zu diesem Anhang : siehe Amtsblatt des Europäischen Patentamts, Nr.12/82